# EUROPÄISCHE PATENTSCHRIFT

(11) **EP 1 240 809 B1**
(45) Veröffentlichungstag und Bekanntmachung des Hinweises auf die Patenterteilung: **11.06.2003**
(21) Anmeldenummer: 00990013.5
(22) Anmeldetag: 21.12.2000
(51) Int. Cl.: H05K 1/03

(54) **MEHRSCHICHTLEITERPLATTE**
MULTILAYER PRINTED BOARD
CARTE A CIRCUIT IMPRIME ET A PLUSIEURS COUCHES

(30) Priorität: 21.12.1999 DE 19961842
(43) Veröffentlichungstag der Anmeldung: 18.09.2002
(73) Patentinhaber: FRAUNHOFER-GESELLSCHAFT ZUR FÖRDERUNG DER ANGEWANDTEN FORSCHUNG E.V., 80636 München (DE); Isola AG, 52353 Düren (DE)
(72) Erfinder: SCHEEL, Wolfgang, 10178 Berlin (DE); KRABE, Detlef, 85570 Markt Schwaben (DE); CYGON, Manfred, 52353 Düren (DE); DIETZ, Mathias, 52353 Düren (DE)
(74) Vertreter: Rösler, Uwe, Dipl.-Phys.
(86) Internationale Anmeldenummer: EP0013121
(87) Internationale Veröffentlichungsnummer: WO01047326

(56) Entgegenhaltungen:
- US-A- 4 609 586
- US-A- 4 882 455
- US-A- 4 939 021
- US-A- 5 687 062
- PATENT ABSTRACTS OF JAPAN vol. 017, no. 583 (E-1452), 22. Oktober 1993 (1993-10-22) & JP 05 175625 A (IBIDEN CO LTD), 13. Juli 1993 (1993-07-13)
- YOSHIYUKI IWATA ET AL: "NEW CERAMIC AND PLASTIC COMPOSITE SUBSTRATE FOR FACE DOWN BONDING & LARGE SIZE SILICON CHIP MOUNTING" PROCEEDINGS OF THE ELECTRONIC COMPONENTS CONFERENCE,US,NEW YORK, IEEE, Bd. CONF. 37, 11. Mai 1987 (1987-05-11), Seiten 392-397, XP000012301 ISSN: 0569-5503
- PATENT ABSTRACTS OF JAPAN vol. 1996, no. 01, 31. Januar 1996 (1996-01-31) & JP 07 249847 A (MITSUBISHI ELECTRIC CORP), 26. September 1995 (1995-09-26)
- PATENT ABSTRACTS OF JAPAN vol. 017, no. 418 (E-1408), 4. August 1993 (1993-08-04) & JP 05 082929 A (IBIDEN CO LTD), 2. April 1993 (1993-04-02)
- PATENT ABSTRACTS OF JAPAN vol. 014, no. 089 (E-0891), 19. Februar 1990 (1990-02-19) & JP 01 298788 A (NIPPON DENSO CO LTD), 1. Dezember 1989 (1989-12-01)
- PATENT ABSTRACTS OF JAPAN vol. 1998, no. 02, 30. Januar 1998 (1998-01-30) & JP 09 270573 A (CMK CORP), 14. Oktober 1997 (1997-10-14)

## Beschreibung

### Technisches Gebiet

Die Erfindung bezieht sich auf ein Verfahren zur Herstellung einer Mehrschichtleiterplatte zur Bestückung mit elektronischen Bauelementen, die wenigstens eine Schicht aufweist, deren thermisches Ausdehnungsverhalten in etwa dem thermischen Ausdehnungsverhalten der elektronischen Bauelementen entspricht und zugleich wesentlich das thermische Ausdehnungsverhalten der Mehrschichtleiterplatte bestimmt.

### Stand der Technik

Der steigende Bedarf an elektronischen Geräten, höhere funktionelle Anforderungen, die eng mit der Weiterentwicklung auf dem Bauelementesektor verbundene Miniaturisierung der Baugruppen und die Forderungen nach einer erhöhten Zuverlässigkeit haben zu einem umfangreichen Spektrum von Leiterplatten geführt.

Dafür ist insbesondere die Dimensionsstabilität (Abmessungskonstanz) der Leiterplatte bei Temperaturbeanspruchung sehr wichtig. Als Kriterium für die Dimensionsstabilität in Abhängigkeit von der Temperatur wird der thermische Ausdehnungskoeffizient α angesehen. Dieser Ausdehnungskoeffizient beträgt für Leiterplatten-Substrate in FR 4 - Qualität (Glasfasergewebe/Epoxidharz) 16-18 ppm/K. Der Ausdehnugskoeffizient für Si-Chips beträgt 3 ppm/K. Damit ist keine Direktmontage von Halbleiterchips ohne zusätzliche Hilfsmittel (z.B. Underfillen) auf der Leiterplatte möglich und damit der Entwicklungsweg der Leiterplatte für die künftige Systemintegration sehr eingeschränkt. Entsprechend dieses Sachverhaltes sind die Schichtpreßstoffe in ihrer Aufbaustruktur so zu modifizieren, daß deren Ausdehnungskoeffizient dem des Siliziums nahekommt.

Als Trägermaterial für Schichtpreßstoffe werden Papiere und Glasseidengewebe, seltener Glasseidenmatten, Glasfaservliese sowie Gewebe auf Quarz- und Aramidfaserbasis verwendet. Das gebräuchlichste Bindemittel ist Epoxidharz.

Unterschiede thermischer Längenausdehnungskoeffizienten der Werkstoffe führen bei Temperaturwechselbeanspruchungen während der Montage oder dem Betrieb elektronischer Baugruppen zu thermisch induzierten mechanischen Spannungen im Verdrahtungsträger sowie in den Verbindungs- und Kontaktstellen, die eine Ermüdung der Kontaktstellen zur Folge haben und im Extremfall zum Bruch derselben führen.

Typische Problembeispiele dafür sind die Differenzen der Ausdehnungskoeffizienten von Epoxidharz-Glasgewebe als Basismaterial für Leiterplatten mit bestückten Silizium-Nacktchips bzw. SMD-Bauelementen. Auch können die Differenzen zwischen den Längenausdehnungskoeffizienten in z-Richtung im Epoxidharz-Glasgewebe beim Lötprozeß zu Rissen in der Lochmetallisierung führen.

Zur Überwindung des Problems muß eine Anpassung der Ausdehnungskoeffizienten der an der Verbindung beteiligten Komponenten herbeigeführt werden. Technisch angewendete Möglichkeiten bezüglich der Ermüdung der Kontaktstellen sind elastische Anschlußelemente der Bauelemente sowie das Underfillen von Nacktchipstrukturen.

Die erste Möglichkeit ist bei flächenhaften Anschlüssen nicht gegeben und die zweite stellt einen zusätzlichen diffizilen Verfahrensschritt dar.

Darüber hinaus ist die Integration mikrotechnischer Funktionsstrukturen in die Mehrlagen-Leiterplatte dadurch nur sehr aufwendig realisierbar.

Aus der US-A-4,939,021 ist eine Mehrschichtleiterplatte zu entnehmen, die Kupferschichten und das thermische Ausdehungsverhalten der Mehrschichtleiterplatte bestimmende, jeweils zwischen den Kuperschichten befindliche Glaskeramikschichten vorsieht. Zur Herstellung einer derartigen Mehrschichtleiterplatte wird jeweils ein pulverförmiges Glaskeramikgemisch unter Beimengung eines Bindemittels zwischen zwei Kupferplatten gegeben. Im weiteren erfolgt ein Sintervorgang, bei dem die Mehrschichtleiterplattenanordnung einer Temperatur ausgesetzt wird, die zumindest die Erweichungstemperatur von Kupfer nicht überschreiten darf, bei der jedoch ein Kristallisations- bzw. Polykristallisationsvorgang zur Bildung einer Sinterglaskeramik erfolgen kann. Ferner ist darauf zu achten, dass sich durch eine geeignete Prozesstemperaturwahl jegliche Anteile des eingebrachten Bindemittels verflüchtigen sollen.

Aus der JP 07 249847 ist ein Verfahren zur Herstellung einer Mehrschichtleiterplatte zur Bestückung mit elektronischen Bauelementen beschrieben, die aus Gründen der Stabilisierung gegenüber unterschiedlicher thermischer Ausdehungsverhalten der einzelnen Schichten eine Schicht aus Glasfasermaterial vorsieht, das mittels eines Epoxidharzes mit einem weiteren Schichtmaterial durch Pressen zu einem Laminat verfügt wird.

Ausgehend von diesem Stand der Technik gilt es nun ein Verfahren zur Hestellung einer Mehrschichtleiterplatte derart anzugeben, dass die Mehrschichtleiterplatte über ein thermisches Ausdehnungsverhalten verfügt, das dem elektrischer Bauelemente, die vorzugsweise überwiegend aus Silizium bestehen, entspricht und darüber hinaus günstiger und einfacher in der Herstellung sein soll.

Die Lösung ist im Anspruch 1 angegeben. Vorteilhafte Weiterbildungen der Erfindung sind Gegenstand der Unteransprüche.

Erfindungsgemäß zeichnet sich das Verfahren zur Herstellung einer Mehrschichtleiterplatte zur Bestückung mit elektronischen Bauelementen, die wenigstens eine Schicht aufweist, deren thermisches Ausdehnungsverhalten in etwa dem thermischen Ausdehnungsverhalten der elektronischen Bauelementen entspricht und zugleich wesentlich das thermische Ausdehnungsverhalten der Mehrschichtleiterplatte bestimmt, dadurch aus, dass eine als Borosilikatglasschicht ausgebildete Dünnglasfolie mit einer Dicke zwischen 30 µm und 1100 µm vermittels einer Harzformulierung mit einem weiteren Schichtmaterial der Mehrschichtleiterplatte durch Pressen zu einem Laminat verfügt wird.

Geeignete Dünnglasfolien sind beispielsweise unter der Typenbezeichnung AF45 und D263 von der deutschen Firma DESAG zu beziehen. Derartige Dünnglasfolien sind Borosilikatglasschichten, die eine typische Schichtdicke zwischen 30 µm und 1,1 mm aufweisen. Vorzugsweise eigenen sich jedoch Dünnglasfolien zum vorgenannten Zweck mit Foliendicken zwischen 50 und 500 µm.

### Kurze Beschreibung der Erfindung

Die Erfindung wird nachstehend ohne Beschränkung des allgemeinen Erfindungsgedankens anhand eines Ausführungsbeispiels unter Bezugnahme auf die Zeichnung exemplarisch beschrieben. Es zeigt:

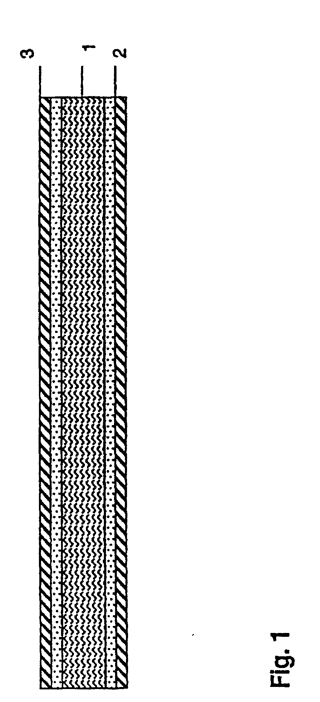

- Fig. 1: Querschnittsdarstellung durch eine Mehrschichtanordnung.

### Wege zur Ausführung der Erfindung, gewerbliche Verwendbarkeit

Aus einer 100 µm dicken Glasfolie (1) wurde zusammen mit einer speziellen Harzformulierung (2) auf Basis von Epoxidharz und einer 18 µm dicken Kupferfolie (3) durch Pressen ein Laminat hergestellt. Das Laminat weist eine Gesamtdicke von 160 µm auf.

Mittels thermomechanischer Analyse (TMA) wurde die Ausdehnung des Laminates unter konstanter Last (100 mN) temperaturabhängig gemessen. Die Aufheizrate lag bei 10°C/min.

Für den Ausdehnungskoeffizienten α wurden folgende Werte ermittelt:
- α₁ (von 40°C bis T_{g}) 6,2 ppm/°C
- α₂ (von T_{g} bis 195 °C) 4,3 ppm/°C
- α₃ (von 40°C bis 195°C) 5,3 ppm/°C

### Bezugszeichenliste

1 Glasfolie
2 Harzschicht
3 Kupferschicht

## Patentansprüche

1. Verfahren zur Herstellung einer Mehrschichtleiterplatte zur Bestückung mit elektronischen Bauelementen, die wenigstens eine Schicht aufweist, deren thermisches Ausdehnungsverhalten in etwa dem thermischen Ausdehnungsverhalten der elektronischen Bauelementen entspricht und zugleich wesentlich das thermische Ausdehnungsverhalten der Mehrschichtleiterplatte bestimmt, wobei
eine als Borosilikatglasschicht ausgebildete Dünnglasfolie (1) mit einer Dicke zwischen 30 µm und 1100 µm vermittels einer Harzformulierung (2) mit einem weiteren Schichtmaterial (3) der Mehrschichtleiterplatte durch Pressen zu einem Laminat verfügt wird.

2. Verfahren nach Anspruch 1,
**dadurch gekennzeichnet, dass** als Dicke der Dünnglasfolie (1) eine Dicke zwischen 50 und 500 µm gewählt wird.

3. Verfahren nach Anspruch 1 oder 2,
**dadurch gekennzeichnet, dass** als Schichtmaterialien (3) thermo- oder duroplastische Materialien, Metalle oder elektrisch leitende oder nicht leitende Kunststoffe verwendet werden.

4. Verfahren nach einem der Ansprüche 1 bis 3,
**dadurch gekennzeichnet, dass** die Dünnglasfolie (1) im Inneren oder als Außenlage der Mehrschichtleiterplatte angeordnet wird.

5. Verfahren nach einem der Ansprüche 1 bis 4,
**dadurch gekennzeichnet, dass** die Dünnglasfolie (1) als Verstärkungsmaterial für Laminate und Prepregs und/oder als Außenlage in Verbindung mit thermo- oder duroplastischen Polymeren verwendet wird.

6. Verfahren nach einem der Ansprüche 1 bis 5,
**dadurch gekennzeichnet, dass** die Schicht perforiert, porösiert, für optische Applikationen strukturiert, bedruckt, physikalisch beschichtet, chemisch beschichtet, im Rolle zu Rolle-Prozeß verarbeitet und/oder thermisch verformt wird.

## Claims

1. Method of manufacturing a multi-layer pc board for the assembly of electronic devices, which comprises at least one layer whose thermal expansion properties correspond approximately to the thermal expansion properties of the electronic devices and, at the same time, determine essentially the thermal expansion properties of the multi-layer pc board, wherein
a thin glass foil (1) configured as borosilicate glass layer, having a thickness of 30 µm to 1100 µm, is joined by means of a resin formulation (2) to a further laminate (3) of the multi-layer pc board by pressing so as to form a laminate.

2. Method according to Claim 1,
**characterised in that** a thickness in the range from 50 to 500 µm is selected as thickness of said thin glass foil (1).

3. Method according to Claim 1 or 2,
**characterised in that** thermoplastic or thermosetting materials, metals or electrically conducting or non-conducting synthetic resins are used as laminates (3).

4. Method according to any of the Claims 1 to 3,
**characterised in that** said thin glass foil (1) is disposed inside or as outside layer of said multi-layer pc board.

5. Method according to any of the Claims 1 to 4,
**characterised in that** said thin glass foil (1) is used as reinforcing material for laminates and prepregs and/or as outside layer in combination with thermoplastic or thermosetting polymers.

6. Method according to any of the Claims 1 to 5,
**characterised in that** said layer is perforated, rendered porous, structured for optical applications, imprinted, physically coated, chemically coated, processed in a roll-to-roll process and/or thermally moulded.

## Revendications

1. Procédé de fabrication d'une carte à circuit imprimé et à plusieurs couches à être munie des composants électroniques, qui comprend au moins une couche, dont les propriétés de dilatation thermique correspondent approximativement aux propriétés de dilatation thermique des composants électroniques et, en même temps, déterminent essentiellement les propriétés de dilatation thermique de la carte à circuit imprimé et à plusieurs couches, dans lequel
la pellicule de verre mince (1) configurée en tant que couche en verre au borosilicate, à une épaisseur de 30 µm à 1100 µm, est jointe, par compression, moyennant une formulation de la résine (2), à un autre stratifié (3) de la carte à circuit imprimé et à plusieurs couches afin de former un stratifié.

2. Procédé selon la revendication 1,
**caractérisé en ce qu'**une épaisseur dans la gamme de 50 à 500 µm est choisie comme l'épaisseur de ladite pellicule de verre mince (1).

3. Procédé selon la revendication 1 ou 2,
**caractérisé en ce que** des matériaux thermoplastiques ou thermodurcissables, des métaux, des résines synthétiques conductrices ou des résines synthétiques non-conductrices sont utilisés en tant que lesdits stratifiés (3).

4. Procédé selon une quelconque des revendications 1 à 3,
**caractérisé en ce que** ladite pellicule de verre mince (1) est disposée à l'intérieur ou comme couche extérieure de ladite carte à circuit imprimé et à plusieurs couches.

5. Procédé selon une quelconque des revendications 1 à 4,
**caractérisé en ce que** ladite pellicule de verre mince (1) est utilisée en tant que matériau de renforcement pour des stratifiés et des matériaux pré-imprégnés et/ou en tant que couche extérieure, en combinaison avec des polymères thermoplastiques ou thermodurcissables.

6. Procédé selon une quelconque des revendications 1 à 5,
**caractérisé en ce que** ladite couche est perforée, rendue poreuse, structurée pour des applications optiques, imprimée, revêtue par moyens physiques, revêtue par moyens chimiques, traitée par un processus rouleau à rouleau et/ou confectionnée par un processus thermique.
